(19) Europäisches Patentamt

European Patent Office

Office européen des brevets

(11) EP 0 937 509 A1

(12) EUROPEAN PATENT APPLICATION
published in accordance with Art. 158(3) EPC

(43) Date of publication:
25.08.1999 Bulletin 1999/34

(51) Int. Cl.⁶: **B08B 1/04**, A47L 25/00

(21) Application number: 97909707.8

(86) International application number:
PCT/JP97/03971

(22) Date of filing: 31.10.1997

(87) International publication number:
WO 98/20987 (22.05.1998 Gazette 1998/20)

(84) Designated Contracting States:
**DE GB IE**

(30) Priority: 08.11.1996 JP 31286796

(71) Applicant: **KANEBO LTD.**
**Sumida-ku, Tokyo 131-0031 (JP)**

(72) Inventors:
• **IGARASHI, Koei**
**Ibaraki 306-02 (JP)**
• **GOHDA, Shuki**
**Ibaraki 306-02 (JP)**

• **IDE, Masao**
**Ibaraki 306-02 (JP)**
• **TOKUNAGA, Konomu**
**Ibaraki 306-02 (JP)**
• **MIYAJI, Hiroshi**
**Chiba 270 (JP)**

(74) Representative:
**Behnisch, Werner, Dr.**
**Reinhard-Skuhra-Weise & Partner,**
**Patentanwälte,**
**Postfach 44 01 51**
**80750 München (DE)**

(54) **SPONGE ROLLER FOR CLEANING**

(57) Many protrusions are provided on the surface of a cleaning sponge roller composed of a polyvinyl acetal-based porous material The top of these protrusions are each formed by a surface layer having a high smoothness. Further, the surface layer has fine openings formed therein.

By using thus constructed cleaning sponge roller, it is possible to provide a cleaning sponge roller which can exert a high cleaning effect for a reduced period of time in the cleaning of the surface of hard disc, silicon wafer, etc.

FIG. 1

EP 0 937 509 A1

## Description

### Technical Field

The present invention relates to a cleaning sponge roller which can remove fine particles such as abrasive grain, swarf and scobs attached to the surface of the material to be cleaned after work step such as polishing at an extremely good efficiency without damaging the surface of the material to be cleaned in the process for the preparation of substrates such as magnetic recording aluminum disc and semiconductor silicon wafer.

### Background Art

In the process for the preparation of hard disc, glass disc, silicon wafer, semiconductor element which is being in CMP work, photomask, liquid glass substrate, etc., high precision abrasion with various abrasive grains such as silicon oxide, alumina and cerium, i.e., so-called polishing is effected to provide the surface of the material with an extremely high precision finish. In this work, the surface of the material to be polished such as hard disc and silicon wafer is contaminated with abrasive grain, scobs, etc. Thus, it is indispensable to clean the material to be polished before the subsequent step.

As a method for cleaning silicon wafer there has been known RCA cleaning which comprises the use of a mixture of aqueous ammonia and hydrogen peroxide and a mixture of dilute hydrofluoric acid, hydrochloric acid and hydrogen peroxide in this order. For the cleaning of hard disc, silicon wafer, etc. which has been polished, a cleaning sponge roller made of a polyvinyl acetal-based (hereinafter referred to as "PVAt-based") porous material has been widely used. In particular, a PVAt-based sponge roller having various protrusions provided on the surface thereof is used to advantage.

For example, in order to clean both sides of a substrate which has been subjected to CMP work in the process for the preparation of semiconductor elements, a scrub cleaning method using an apparatus for clamping the substrate by two PVAt-based sponge rollers is employed by which the substrate is allowed to come in contact with the rotating PVAt-based sponge rollers while the surface of the material to be cleaned is being filled with an aqueous cleaning fluid such as pure water and aqueous solution of detergent. As the method for supplying the cleaning fluid there has been known a method which comprises spraying the cleaning fluid through a nozzle positioned directly or obliquely above the sponge roller or a method which comprises supplying the cleaning fluid from the interior of the PVAt-based sponge roller.

As the cleaning fluid there has been proposed pure water if the surface of silicon wafer substrate is an oxide layer or a chemical liquid such as hydrofluoric acid and ammonia for the purpose of controlling $\zeta$ potential to minus if the surface of silicon wafer substrate is a tungsten layer or the like.

The demand for the cleanness of the surface of the substrate which has been cleaned is growing more and more every year. The trend for the demand for the cleanness of the surface of the substrate is for less absolute number of grains having a smaller size to remain on the surface of the substrate. At the same time, the trend for the time required until the foregoing demand for cleanness is met is for shorter time to be used.

The growing demand for cleanness has recently been met by the prior art cleaning sponge rollers hardly more and more.

In order to cope with the growing demand for cleanness, the inventors made extensive studies of the surface of cleaning sponge rollers which come in direct contact with the surface of the material to be cleaned, focusing particularly on the surface conditions thereof. As a result, the present invention has been worked out.

The cleaning methods with the foregoing prior art cleaning materials cannot sufficiently cope with the growing demand for cleanness in the cleaning of hard disc, silicon wafer, etc. Further, shorter time has been required for cleaning.

It is therefore an object of the present invention to provide a cleaning material which can exert a high cleaning effect for a reduced period of time.

### DISCLOSURE OF THE INVENTION

A cleaning sponge roller according to the present invention is composed of an elastic polyvinyl acetal-based porous sponge having a large number of protrusions provided on the surface thereof which is adapted to be rotated in such a manner that the top of said protrusions come in contact with the surface of the material to be cleaned so that the material to be cleaned is cleaned, characterized in that the top of said protrusions are formed by a surface layer having a high smoothness.

The cleaning sponge roller comprises a sponge having a proper elasticity and flexibility. In this arrangement, when the material to be cleaned is cleaned, the protrusions formed on the cleaning sponge roller is compressed so that

2

the top of the protrusions on the sponge roller come into intimate contact with the material to be cleaned without any clearance. Further, these protrusions are provided on the surface of the sponge roller in a large number, and the top of these protrusions together form an imaginary columnar profile having a high roundness. Moreover, the top of these protrusions are each formed by a surface layer having a high smoothness. In this arrangement, the area on the top of these protrusions with which the material to be cleaned comes in contact can be substantially increased, adding to the cleaning capacity of the sponge roller.

The upper limit of the surface roughness of the top of the protrusions is 50 μm. In this arrangement, the probability that the surface layer of the material to be cleaned can come in contact with the particulate material attached to the surface which has been polished to a high precision can be raised, making it possible to provide a sufficient cleaning capacity. Thus, the cleaning sponge roller of the present invention can be substantially applied to materials requiring a high flatness such as hard disc and silicon wafer. The upper limit of the surface roughness of the top of the protrusions is preferably 30 μm because grains attached to the surface of the material to be cleaned can be more efficiently removed.

The percent surface opening attained by relatively large openings having a major axis length of not less than 40 μm on the top of said protrusions is in the range of 1 to 20%. In this arrangement, the surface of the top of the protrusions is not filled with many large holes but has proper openings. Thus, the smoothness of the surface layer is substantially raised, making it possible to obtain an ideal smoothened surface. Accordingly, the cleaning sponge roller of the present invention can clean materials requiring a high flatness such as hard disc and silicon wafer at a higher efficiency. More preferably, the upper limit of the percent surface opening attained by relatively large openings having a major axis length of not less than 40 μm on the surface layer is 10% because the particulate material which has been removed from the material to be cleaned and then taken into the interior of the sponge roller can hardly be discharged from the openings to re-contaminate the material to be cleaned during scrub cleaning.

The top of said protrusions have fine openings distributed uniformly a major axis length of not less than 40 μm on the surface thereof and the percent surface opening attained by said fine openings is in the range of 1 to 20%. In this arrangement, water is always allowed to present uniformly on the interface, making it possible to enhance the effect of scratching particularly fine particles having a size of less than 0.5 μm off the surface of the material to be cleaned.

Further, the cleaning sponge roller of the present invention is composed of a hydrophilic polyvinyl acetal-based porous material and thus has an excellent water retention and flexibility. In this arrangement, when the material to be cleaned is cleaned while the sponge roller is being pressed against the surface of the material to be cleaned with an aqueous cleaning fluid such as pure water and aqueous solution of detergent being sprayed thereonto, the cleaning fluid can be uniformly spread over the surface of the material to be cleaned, making it possible to remove grains or contaminants attached to the surface of the material to be cleaned at an extremely high efficiency and hence clean the material to be cleaned without damaging it. The polyvinyl acetal-based porous material is also excellent in abrasion resistance and durability.

The cleaning sponge roller of the present invention has many protrusions provided on the surface thereof. In this arrangement, the contact force and abrasion resistance between the sponge roller and the material to be cleaned can be lowered as compared with the case where a flat roller is used, making it possible to clean the surface of the material which has been polished to a high precision without damaging it. Further, the supply and discharge of the cleaning fluid can be smoothly effected, making it possible to discharge particulate material efficiently.

The acetalation degree of the polyvinyl acetal as a material constituting the sponge roller of the present invention is preferably from 50 to 75%. A sponge roller composed of a polyvinyl acetal having an acetalation degree of not less than 50% forms a porous material having a certain strength and has a proper elasticity. Further, the restriction of the upper limit of the acetalation degree of polyvinyl acetal to not more than 75% causes hydrophilic groups to remain, providing the sponge roller with excellent water retention and flexibility.

The cleaning sponge roller of the present invention is composed of a porous sponge having a proper elasticity, preferably having a 30% compression stress of from 15 to 400 gf/cm$^2$ as determined when impregnated with water in an amount of 100% based on the dry weight thereof. The restriction of 30% compression stress to the above defined range makes it possible to provide the resulting porous sponge with excellent elasticity and flexibility. If used as a cleaning sponge roller, the porous sponge of the present invention preferably has a 30% compression stress of from 40 to 150 gf/cm$^2$.

The porous material constituting the sponge roller of the present invention has fine pores incorporated therein. The average pore diameter suitable for cleaning purpose is from 40 to 400 μm.

Further, the porosity of the interior of the porous material constituting the sponge roller of the present invention is preferably from 80 to 95% because the resulting sponge roller is provided with flexibility and strength suitable for cleaning purpose and a high cleaning effect. The percent surface opening of the top of the protrusions on the sponge roller of the present invention is preferably not more than 60%. The surface layer constituting the top of the protrusions is essentially different from the interior of the porous material constituting the sponge roller in structure.

BRIEF DESCRIPTION OF THE DRAWINGS

Fig. 1 is a diagram illustrating a cleaning sponge roller according to the present invention.
Fig. 2 is a diagram illustrating the protrusions on the foregoing cleaning sponge roller.
Fig. 3 is a diagram illustrating how the foregoing cleaning sponge roller is used.
Fig. 4 is a diagram illustrating an apparatus for the preparation of the foregoing cleaning sponge roller.

BEST MODE FOR CARRYING OUT THE PRESENT INVENTION

Embodiments of the implementation of the present invention will be further described with reference to the accompanying drawings.

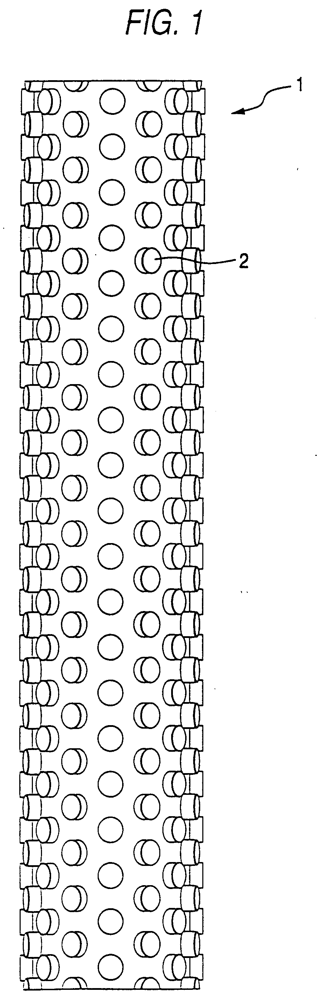

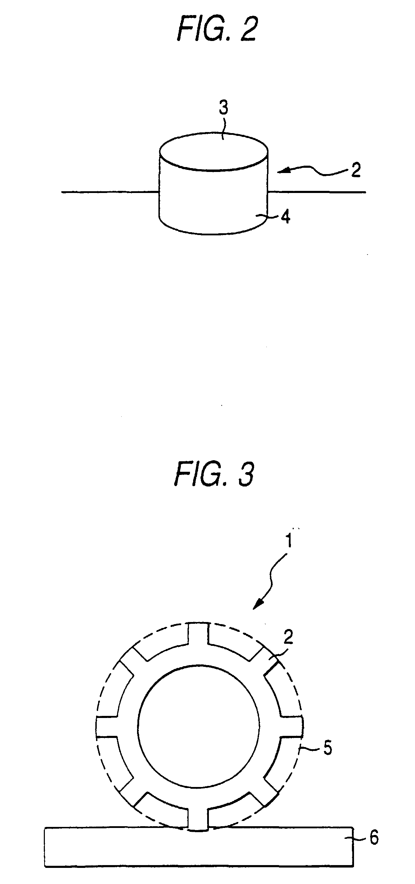

An embodiment of the cleaning sponge roller of the present invention is shown in Fig. 1. The cleaning sponge roller 1 has many protrusions 2 provided on the surface thereof. As shown in Fig. 2, the protrusion 2 has a body portion 4. The top 3 of the protrusions are each formed by a surface layer having a high smoothness. As shown in Fig. 3, the top of the protrusions 2 together form an imaginary columnar profile 5 which comes in contact with the material 6 to be cleaned when rotated to effect scrub cleaning.

The protrusions are provided on the same one column at an equal interval. The column of the protrusions in the peripheral direction is provided at an equal interval. Further, regarding to the arrangement of the protrusion, a protrusion on the next column is provided at a position which corresponds to a gap between protrusions on one column.

Thus, it is possible to realize an equal cleaning without uneven cleaning, and to realize highly precious cleaning in a short time.

Incidentally, in Fig. 1, the column direction of the protrusions are consistent with the axial direction of the roller However, the direction of the protrusion column is provided at the angle in the range of 0 to 45° with respect to the axial line of the roller.

However, the arrangement of the protrusions is not limited to the above conditions.

The shape of the protrusion are not limited to the columnar shape, but can be long circular or half spherical.

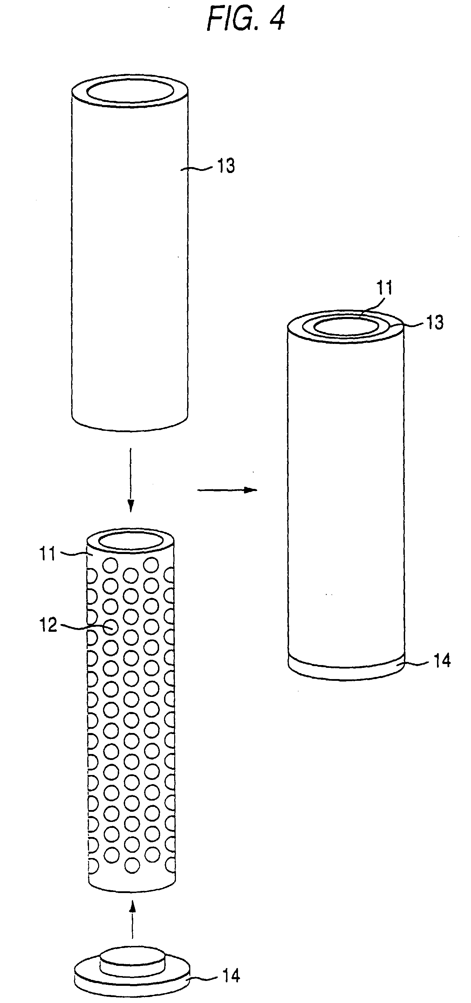

An example of the constitution of the mold for use in the preparation of the cleaning sponge roller of the present invention is shown in Fig. 4, but the present invention is not limited thereto. The mold for use in the preparation of the cleaning sponge roller according to Fig. 4 comprises a first cylindrical mold unit 11 having many holes 12 made through the periphery thereof, a lid 14 for covering the bottom of the first cylindrical mold unit 11, and a second mold unit 13 having a smooth inner surface for covering the first cylindrical mold unit 11. The inner surface of the second mold unit 13 forms a column having a high roundness. Into the mold having the foregoing constitution is then poured a sponge reaction solution. The sponge reaction solution flows into the holes made through the periphery of the first cylindrical mold unit 11 where it then undergoes reaction and solidification so that many protrusions are formed on the periphery of the sponge roller.

In this arrangement, the top of the protrusions on the sponge roller together form a new imaginary profile corresponding to the inner surface of the foregoing second mold unit 13. Since the inner surface of the second mold unit 13 forms a column having a high roundness, the imaginary profile formed by the top of the protrusions on the sponge roller, too, forms a column having a high roundness.

Further, since the inner surface of the foregoing second mold unit 13 has a high smoothness, the sponge reaction solution which has flown into the holes 12 to the periphery of the mold unit 11 comes in contact with the inner surface of the second mold unit 13 having a high smoothness. In this manner, after reaction and solidification, a surface layer having a high smoothness is formed on the top of the protrusions on the sponge roller.

In order to form the top of the protrusions on the sponge roller by a surface layer having a high smoothness by separating the second mold unit from the first mold unit into which the second mold unit has been fitted, it is not necessary that the entire inner surface of these mold units be taken into account. It needs only to consider the inner surface of the second mold unit alone so that its smoothness is raised. Thus, the entire cost of these mold units can be reduced.

The constitution of the mold by three separable portions, i.e., first mold unit, lid for closing the bottom of the first mold unit and second mold unit makes it easy to release the sponge roller obtained by solidification reaction from the mold and clean the mold thereafter.

The average pore diameter, porosity, percent surface opening, surface roughness, acetalation degree and 30% compression stress of the cleaning sponge roller of the present invention, including those of the following examples, were measured according to the following methods.

(Measurement of average pore diameter)

The measurement of average pore diameter was effected in accordance with ASTM (Designation: D4404-84). In some detail, a porosimeter available from POROUS MATERIALS, INC. A mercury pressing method was employed to measure the diameter of pores. Thus, the average pore diameter was determined.

(Measurement of porosity)

The sample was dried at 60°C for 3 hours, and then measured for apparent volume (Va) by means of a vernier caliper and true volume (V) by means of Acubic 1330 (dry automatic densimeter available from Shimadzu Corp.). The percent porosity ε was calculated from these values by the following equation:

$$\varepsilon = (1 - V/Va) \times 100$$

where Va is apparent volume, and V is true volume.

(Measurement of percent surface opening)

The top of the protrusions on the sponge roller was taken electron micrograph of. The electron micrograph was then image-processed. In this manner, the ratio of opening formed by exposed pore in the sublayer to the total image area was represented by area ratio.

$$\% \text{ Surface opening} = \text{Total of area of openings having predetermined size/total image area} \times 100$$

However, in the case of the measurement of the percent surface opening attained by openings having a major axis length of not less than 40 μm on the surface layer, openings having a major axis length of not less than 40 μm were extracted from the area of photographic image corresponding to a size of 1,000 μm x 1,400 μm for calculation. Further, in the case of the measurement of the percent surface opening attained by openings having a major axis length of less than 40 μm on the surface layer, openings having a major axis length of from 1 to 40 μm were extracted from the area of photographic image corresponding to a size of 100 μm x 140 μm selected such that no openings having a major axis length of not less than 40 μm appear.

(Measurement of surface roughness)

The protrusion on the sponge roller was cut vertically in such a manner that the curvature of the top doesn't appear on the section. The section was then taken electron micrograph of in such a manner that the border of the top sponge of the protrusion appears. The sponge border was then image-processed. The sponge border thus processed was then extracted as a curve $y = f(x)$. The surface roughness Ra was determined from the following equation where L is the length of the extracted curve $y = f(x)$ in the direction of x, and $y = g(x)$ is the central line on the extracted curve $y = f(x)$.

$$Ra = 1/L \int_0^L ABS(f(x) - g(x)) \, dx$$

(Measurement of acetalation degree)

Proton NMR measurement in deuterochloroform and aqueous solution of trifluoroacetic acid was effected. From these measurements the acetalation degree F was then calculated by the following equation:

$$F = (a/c) \times 100$$

c: Total of peak intensities of methyne (CH) proton (e.g., at 4.153 ppm, 4.442 ppm)
a: Total of peak intensities of methylene ($CH_2$) proton adjacent to ether group (e.g., at 4.667 ppm, 5.150 ppm, 5.313 ppm, 5.325 ppm)

(Measurement of 30% compression stress)

The sponge roller was cut crosswise to a thickness of about 30 mm. The load under which the sample is crosswise compressed by 30% at a rate of 30 mm/min. was then divided by the section area except that of the protrusions to determine 30% compression stress.

EXAMPLE 1

9 kg of a fully-saponified polyvinyl alcohol resin having an average polymerization degree of 1,500 was poured into water to make 70 l. The solution thus prepared was heated to about 100°C where it was then thoroughly stirred so that the polyvinyl alcohol resin was completed dissolved in water. To the solution was then added water to make 85 l. To the solution was then added a starch dispersion obtained by a process which comprises dispersing 5 kg of potato starch as a pore-forming agent in water to make 15 l. The mixture was then stirred. Subsequently, to the solution were added 9 l of a 50% sulfuric acid and 20 l of a 37% aqueous solution of formaldehyde. The mixture was immediately stirred to obtain a sponge reaction solution.

The sponge reaction solution thus obtained was casted into a reaction mold having the constitution shown in Fig. 4 where it was then reacted at 60°C for 18 hours. The reaction product was withdrawn, and then rinsed to remove the pore-forming agent therefrom to obtain a cleaning sponge roller made of a PVAt-based porous material.

Since the second mold unit 13 among the reaction molds shown in Fig. 4 had an inner surface constituting a completely round column, the smoothness of the surface layer on the protrusions provided on the cleaning sponge roller was as good 25 μm.

Further, the surface layer had many relatively large openings having a major axis length of from about 40 to 150 μm (percent surface opening: 8%) and many relatively small openings having a major axis length of from about 4 to 15 μm (percent surface opening: 10%) shown uniformly distributed thereon.

The cleaning sponge roller showed a porosity of 90%, an average pore diameter of 130 μm and an acetalation degree of 67 mol-%. The PVAt-based porous material exhibited a 30% compression stress of 60 gf/cm² as determined when impregnated with water in an amount of 100% based on the dry weight thereof.

The cleaning sponge roller used in the evaluation of cleaning Capacity had a diameter of 60 mm (including the protrusions) and a length of 150 mm. The cleaning sponge roller was applied to the cleaning of a 3.5 inch diameter aluminum disc for hard disc which had been finally polished with free abrasive grains, and then roughly washed with flowing water. As the cleaning fluid there was used pure water the presence of particles in which had been controlled. The testing apparatus was arranged such that the cleaning fluid was sprayed onto the material to be cleaned in front and in the rear of the cleaning sponge roller. The experiment conditions were as follows. Five measurements were averaged.

Feed rate of aluminum disc: 5 m/min.
Rotary speed of cleaning sponge roller: 100 RPM and 200 RPM
Contact pressure: 10 gf/cm²

The testing time was predetermined. Thus, the number of residual particles after the test was measured under a microscope.

The results are set forth in Tables 1 and 2. The number of residual particles having a size of not less than 0.5 μm and not less than 0.1 μm was very small. This demonstrates that the sponge roller exerts a very excellent cleaning effect.

COMPARATIVE EXAMPLE 1

A cleaning sponge roller was prepared in the same manner as in Example 1 except that a conventional unseparatable mold was used. The results of evaluation are set forth in Tables 1 and 2.

The comparison of Example 1 with Comparative Example 1 shows that the more rough the surface layer of the top of the protrusions is, the greater is the number of residual particles and the poorer is the cleanness of the aluminum disc. Comparative Example 1 showed more residual particles. The value was too high for the recent cleaning purpose requiring a high cleanness. This is because if the roughness is high, the area of the cleaning sponge roller which comes in contact with particles when allowed to come in contact with the surface of the material to be cleaned is reduced.

Further, when the rotary speed of the cleaning sponge roller was switched from 100 RPM to 200 RPM, the number of residual particles was reduced with any smoothness.

Table 1

| Item | Surface roughness (Ra) of surface layer of the top of protrusions | Percent surface opening attained by openings having a major axis length of not less than 40μm in the surface layer | Percent surface opening attained by opening having a major axis length of less than 40μm in the surface layer |
|---|---|---|---|
| Example 1 | 25μm | 3% | 14% |
| Comparative Example 1 | 100μm | 35% | 30% |

Table 2

| | Cleaning Evaluation | | |
|---|---|---|---|
| | Rotary speed of cleaning sponge roller | Number of residual particles not less than 0.5μm | Number of residual particles not less than 0.1μm |
| Example 1 | 100 | 5 | 60 |
| | 200 | 2 | 45 |
| Comparative Example 1 | 100 | 80 | 520 |
| | 200 | 65 | 440 |

## POSSIBILITY OF INDUSTRIAL UTILITY

The cleaning sponge roller of the present invention relates to a cleaning sponge roller used in the technical field of cleaning for a hard disc, silicon wafer, etc., a surface layer having a high smoothness is formed on the top of many protrusions provided on the surface thereof. In this arrangement, the cleaning sponge roller can clean the material at an extremely high efficiency for a reduced period of time.

## Claims

1.    A cleaning sponge roller composed of an elastic polyvinyl acetal-based porous sponge having a large number of protrusions provided on the surface thereof which is adapted to be rotated in such a manner that the top of said protrusions come in contact with the surface of the material to be cleaned so that the material to be cleaned is cleaned, characterized in that the top of said protrusions are formed by a surface layer having a high smoothness.

2.    The cleaning sponge roller according to Claim 1, wherein the surface roughness of the top of said protrusions is not more than 50 μm.

3.    The cleaning sponge roller according to Claim 1 or 2, wherein the percent surface opening attained by openings having a major axis length of not less than 40 μm on the top of said protrusions is in the range of 1 to 20%.

4.    The cleaning sponge roller according to any one of Claims 1 to 3, wherein the top of said protrusions have fine openings distributed uniformly a major axis length of 1 to 40 μm on the surface thereof and the percent surface opening attained by said fine openings is in the range of 1 to 20%.

## FIG. 1

*FIG. 2*

*FIG. 3*

# FIG. 4

## INTERNATIONAL SEARCH REPORT

| | |
|---|---|
| International application No. |
| PCT/JP97/03971 |

**A. CLASSIFICATION OF SUBJECT MATTER**

Int. Cl$^6$   B08B1/04, A47L25/00

According to International Patent Classification (IPC) or to both national classification and IPC

**B. FIELDS SEARCHED**

Minimum documentation searched (classification system followed by classification symbols)

Int. Cl$^6$   B08B1/00-11/04, H01L21/304, A47L25/00, G11B5/84

Documentation searched other than minimum documentation to the extent that such documents are included in the fields searched

| | |
|---|---|
| Jitsuyo Shinan Koho | 1926 – 1996 |
| Kokai Jitsuyo Shinan Koho | 1971 – 1996 |
| Toroku Jitsuyo Shinan Koho | 1994 – 1997 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP, 8-117717, A (Kanebo, Ltd.), May 14, 1996 (14. 05. 96)(Family: none) | 1 – 4 |
| A | JP, 5-28759, Y2 (Kanebo, Ltd.), July 23, 1993 (23. 07. 93)(Family: none) | 1 – 4 |
| A | JP, 60-186085, U (Kanebo, Ltd.), December 10, 1985 (10. 12. 85)(Family: none) | 1 – 4 |
| A | JP, 1-6953, Y2 (Kanebo, Ltd.), February 23, 1989 (23. 02. 89)(Family: none) | 1 – 4 |
| A | JP, 59-6974, A (Kanebo, Ltd.), January 14, 1984 (14. 01. 84)(Family: none) | 1 – 4 |

☐ Further documents are listed in the continuation of Box C.   ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| December 22, 1997 (22. 12. 97) | February 10, 1998 (10. 02. 98) |

| Name and mailing address of the ISA/ | Authorized officer |
|---|---|
| Japanese Patent Office | |
| Facsimile No. | Telephone No. |

Form PCT/ISA/210 (second sheet) (July 1992)